# EUROPEAN PATENT SPECIFICATION

(11) **EP 3 170 182 B1**
(45) Date of publication and mention of the grant of the patent: **10.10.2018**
(21) Application number: 15822126.7
(22) Date of filing: 03.06.2015
(51) Int. Cl.: G21F 5/008, G21F 5/10, G21C 19/02, G21C 19/07, G21C 19/32, G21H 1/10

(54) **A SOURCE OF ELECTRICITY DERIVED FROM A SPENT FUEL CASK**
STROMQUELLE AUS EINEM BEHÄLTER FÜR ABGEBRANNTE BRENNSTOFFE
SOURCE D'ÉLECTRICITÉ RÉALISÉE À PARTIR D'UN CHÂTEAU DE TRANSPORT DE COMBUSTIBLE USÉ

(30) Priority: 16.07.2014 US 201414332415
(43) Date of publication of application: 24.05.2017
(73) Proprietor: Westinghouse Electric Company LLC, Cranberry Township, PA 16066 (US)
(72) Inventor: DEDERER, Jeffrey T., Valencia, Pennsylvania 16059 (US); STANSBURY, Cory A., Beaver Falls, Pennsylvania 15010 (US); LLOYD, Timothy M., Santa Cruz, California 95060 (US); LU, Baofu, Seven Fields, Pennsylvania 16046 (US); GULER, Cenk, Irwin, Pennsylvania 15642 (US); TATLI, Emre, Pasadena CA91106 (US)
(74) Representative: Gallo, Wolfgang
(86) International application number: PCT/US2015/033892
(87) International publication number: WO 2016/010642

(56) References cited:
- EP-A2- 2 973 985
- WO-A2-2008/097381
- JP-A- H07 120 591
- KR-A- 20140 058 544
- US-A- 4 527 067
- US-A1- 2011 286 567
- US-A1- 2013 111 927
- US-A1- 2014 177 775
- US-B1- 6 252 923

## Description

### CROSS REFERENCE TO RELATED APPLICATIONS

This application claims priority to U.S. patent application serial No. 13/798,271, entitled "A Source Of Electricity Derived From A Spent Fuel Cask," filed March 13, 2013.

### BACKGROUND

### 1. Field

This invention pertains generally to power sources that derive their energy from decay heat and, more particularly, from such a power source that derives its energy from a nuclear spent fuel storage cask containing spent nuclear fuel.

### 2. Related Art

Pressurized water nuclear reactors are typically refueled on an 18-month cycle. During the refueling process, a portion of the irradiated fuel assemblies within the core are removed and replaced with fresh fuel assemblies which are relocated around the core. The removed spent fuel assemblies are typically transferred under water to a separate building that houses a spent fuel pool in which these radioactive fuel assemblies are stored. The water in the spent fuel pools is deep enough to shield the radiation to an acceptable level and prevents the fuel rods within the fuel assemblies from reaching temperatures that could breach the cladding of the fuel rods, which hermetically house the radioactive fuel material and fission products. Cooling continues at least until the decay heat within the fuel assemblies is brought down to a level where the temperature of the assemblies is acceptable for dry storage. Typically, the spent fuel assemblies are stored in such pools for a period of fifteen years during which the assemblies can be cooled while they produce decay heat which decays exponentially with time. After fifteen years, the decay heat has decreased sufficiently that the assemblies can be removed from the spent fuel pool and transferred into long-term storage casks, each typically capable of holding 21 or more assemblies. These casks are generally relocated to another area on the nuclear plant site and stored indefinitely.

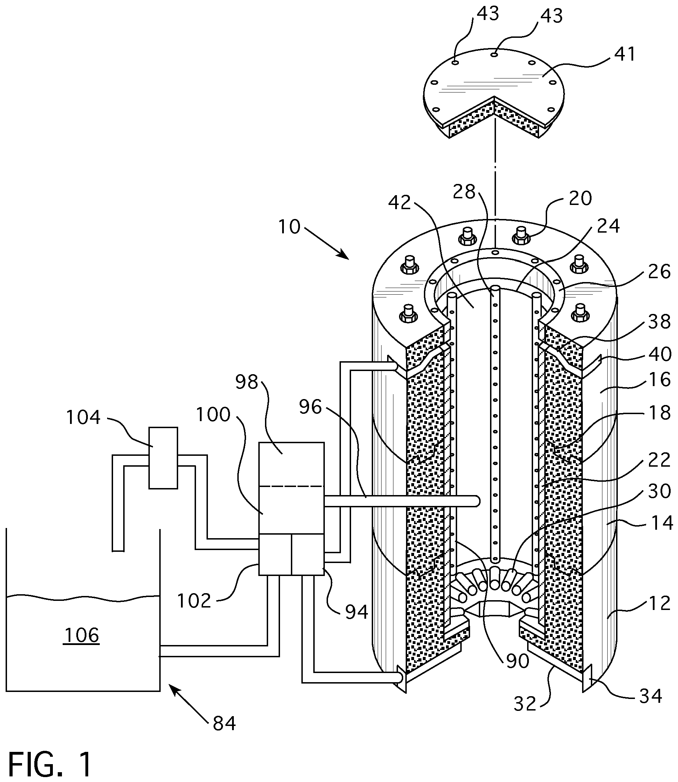

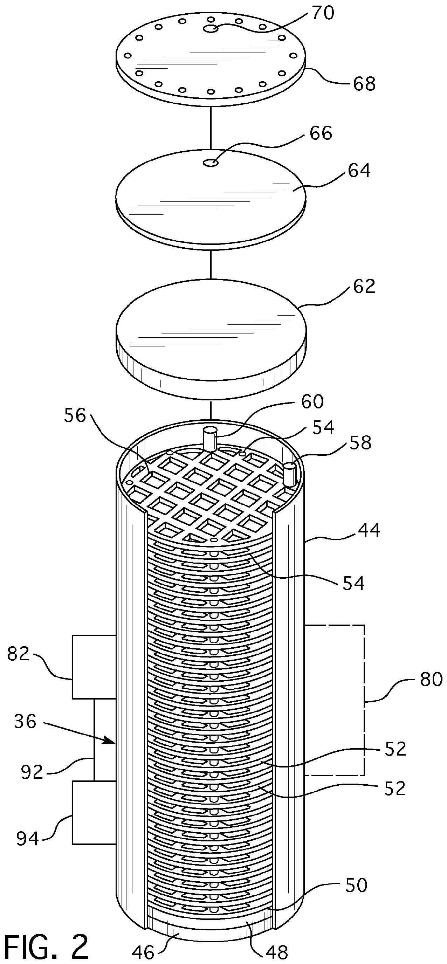

Since the fuel assemblies continue to produce decay heat in the casks, a natural convection air flow is used to provide for heat removal. This keeps the interior cask's temperatures at a level that is suitable for the materials used. Each cask has an interior stainless steel cylindrical canister that contains the spent fuel assemblies. This canister is placed in the storage casks' structural housing which is a thick reinforced cylindrical concrete shell that is lined on the inside face with stainless steel. In one such design there is an approximately 8.89 cm (3.50 inch) radial gap between the inner canister and the outer casks housing when assembled. This geometrical arrangement is shown in Figures 1 and 2. Figure 1 shows the casks shell 10 cut away without the inner canister installed. The casks shell 10 typically comprises three annular concrete sections, a lower segment 12, a middle segment 14 and an upper segment 16, that are laterally restrained by shear keys 18 and are held in position by the tie rods 20. A steel liner 22 surrounds the interior of the segments 12, 14 and 16 and is capped by a thermal shield 24 and annular shield ring 26. Support rails 28 vertically extend along the interior of the segments 12, 14 and 16 and guide the stainless steel canister into position and space the canister from the interior walls of the steel liner 22. Support tubes 30 at the lower end of the central opening 42 in the outer segments 12, 14 and 16, support the inner stainless steel canister 36 shown in Figure 2. An air inlet 32 typically capped by a screen 34 funnels air through the lower portion of the bottom segment 12 of the concrete shell 10 through the interior of the concrete shell into the annular passage between the shell 10 and the interior cylindrical canister that fits within the central opening in the concrete outer shell 10. The air entering through the intake 32 is exhausted through an air outlet passage 38 in the upper segment 16 of the concrete shell 10 that is capped by a screen 40. Typically, there are multiple air intakes 32 and air outlet passages 38 circumferentially spaced around the outer cask 10A top cover 41 is sealed by bolts 43 which extend through the cover and into the annular sealed ring 26 to secure the cover and the interior cylindrical canister 36 once filled with fuel assemblies and loaded within the central opening 42 of the concrete shell 10.

Figure 2 shows the interior canister 36 that slides inside the outer concrete shell 10. The inner canister 36 has an outer steel shell 44 that is closed at the lower end by a bottom end plate 46 that covers a bottom shield plug 48 which is seated over a bottom closure plate 50. Spacer plates 52 are arranged within the inner canister shell 44 in a spaced tandem array and have substantially aligned square openings 56 into which the individual fuel assemblies are positioned. The aligned openings 56 maintain a designed spacing between fuel assemblies. The spacer plates 52 are held in position by an assembly of support rods 54 which extend therethrough around the perimeter of the spacer plates. A drain port 58 and vent port 60 span substantially the length of the canister shell 44 to evacuate water in the canister. The top of the canister 36 is closed by a top shield plug 62 which is covered by a top inner closure plate 64. The top inner closer plate 64 includes an instrument port 66 which communicates with radiation and temperature monitors within the canister to communicate corresponding output signals to the exterior of the canister 36. The inner canister assembly is covered by a top outer closure plate 68 fastened in place by circumferential bolts and includes a leak test port 70 for assuring a hermetical seal on the inner canister.

The flow of cooling air enters the annulus at the bottom of the cask's shell 10 through the radial inlet passages 32 and the heating that incurs within the annulus between the inner canister 36 and the steel liner 22 of the outer concrete shell 10 induces a natural draft of air which is exhausted through the radial outlet passages 38 at the top of the cask. The residual decay heat from the spent fuel is thus dissipated over time to the surrounding environment.
A spent fuel storage container as defined in the pre-characterizing portion of claim 1 is disclosed in document EP 2 973 985 A2. Further relevant prior art is found in documents US 2013/0 111 927 A1, US 4 527 067 A and JP H07 120 591 A.

It is an object of this invention to convert the waste heat from spent nuclear fuel within a spent nuclear fuel storage cask to useful work.

It is a further object of this invention to convert such waste heat to an energy source that can be used to further cool the spent fuel cask so that it can dissipate the heat from the spent fuel at an increased rate.

It is an additional object of this invention to convert such waste heat to mechanical or electrical energy which can be employed as an auxiliary power source for the facility in which the cask is stored.

### SUMMARY

These and other objects are achieved by a spent nuclear fuel storage container according to claim 1, having a canister for storing nuclear fuel and a heat engine in heat transfer relationship with the canister for converting a differential in heat between the latent heat of the stored nuclear fuel and an ambient environment, into electrical or mechanical power. In one embodiment, the spent nuclear fuel storage container includes an outer cask surrounding the canister with an annular space therebetween. An air intake extends through a lower portion of the cask, extending from outside the cask to the annular space. An air outlet extends through an upper portion of the cask, extending from the annular space to the outside of the cask. Preferably, the heat engine is in heat transfer relationship with the annular space. In one embodiment, the heat transfer relationship is implemented through a heat transfer medium to transport heat from the annular space to an exterior of the outer cask. In one such embodiment, the heat transfer medium is a heat pipe and the heat engine may be selected from a Rankine cycle engine, a Stirling cycle engine or a thermoelectric device.

In another embodiment, the heat engine has an electrical output that is connected to a coolant circulation system operable to cool a coolant. Preferably, the circulation system extends through the annular space between the outer cask and the inner canister and through the cask to the exterior thereof, with the coolant circulation system circulating a fluid coolant between an interior of the annular space and the exterior of the cask.

In still another embodiment, the spent nuclear fuel storage container includes a coolant circulation system that cools the fluid within a spent fuel pool of a nuclear power plant. Desirably, the electric power forms an auxiliary power source for the nuclear plant.

According to the invention, the spent nuclear fuel storage container includes a fluid circulation system for circulating a cooling fluid over at least a portion of a circumference of the canister, with the fluid circulation system having a fluid inlet and a fluid outlet which extends through a shield cask that surrounds the canister. A fluid baffle system is provided in fluid communication with the fluid outlet which is supported on the shield cask, with the heat engine supported, at least in part, in the fluid baffle system in heat exchange relationship with the fluid exhausted from the fluid outlet. The fluid baffle system is a substantially annular passage that fits around the shield cask. Preferably the fluid baffle system is supported from an upper portion of the shield cask and the fluid baffle system has an inlet that is substantially hermetically sealed to the fluid outlet.

In yet a further embodiment the fluid circulation system has a plurality of fluid outlets circumferentially spaced around the shield cask and the fluid baffle system is in fluid communication with at least several of the fluid outlets. In the latter embodiment a perforated tube or plate is supported within the fluid baffle system in fluid communication with the fluid outlet, with the perforated tube or plate extending at least partially through the fluid baffle system for distributing the fluid over a fluid path through the baffle system. Preferably the heat engine is a plurality of thermoelectric generators that are supported through the fluid path through the fluid baffle system. Desirably, fins extend on the outside of the baffles support structure to promote heat transfer and the fluid path extends vertically in a serpentine course.

### BRIEF DESCRIPTION OF THE DRAWINGS

A further understanding of the invention can be gained from the following description of the preferred embodiments when read in conjunction with the accompanying drawings in which:
Figure 1 is an isometric view of the outer shell of a spent fuel casks partially exploded to show the top cover removed and partially in section exposing the interior thereof; Figure 1 also schematically shows several illustrative embodiments of the application of waste heat from the spent nuclear fuel to power various facets of a nuclear facility, which are not part of the present invention.
Figure 2 is an isometric view of an inner canister of a spent nuclear fuel cask partially exploded and cut away to expose the interior thereof that houses the spent nuclear fuel assemblies;
Figure 3 is a schematic of a thermoelectric module that can be used as part of the power generation system employed in one embodiment of the spent nuclear fuel cask illustrated in Figures 1 and 2;
Figure 4 is a graphical representation of the temperature profile of the outer concrete shell and inner canister surfaces of the spent fuel cask of Figures 1 and 2;
Figure 5 is an isometric view of a spent fuel cask showing the outer concrete shell with the inner canister partially removed;
Figure 6 is a schematic view of a cross-section of part of a spent fuel outer concrete shell showing the cooling air path extending through according to this invention; and
Figure 7 is a graphical representation of power output vs. temperature differential across one example of a thermoelectric generator that can be employed with this invention.

### DESCRIPTION OF THE PREFERRED EMBODIMENT

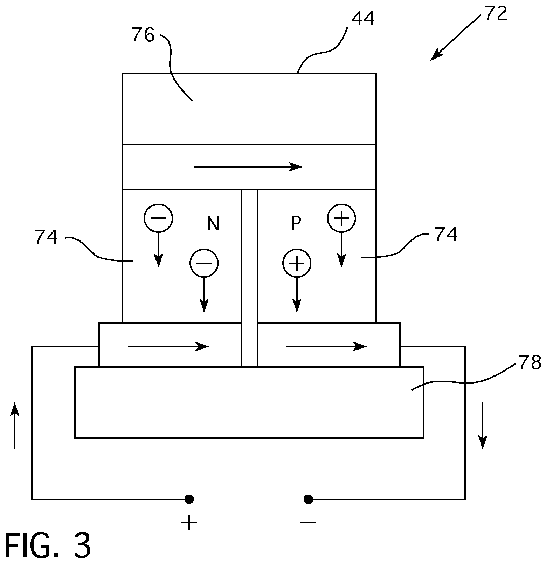

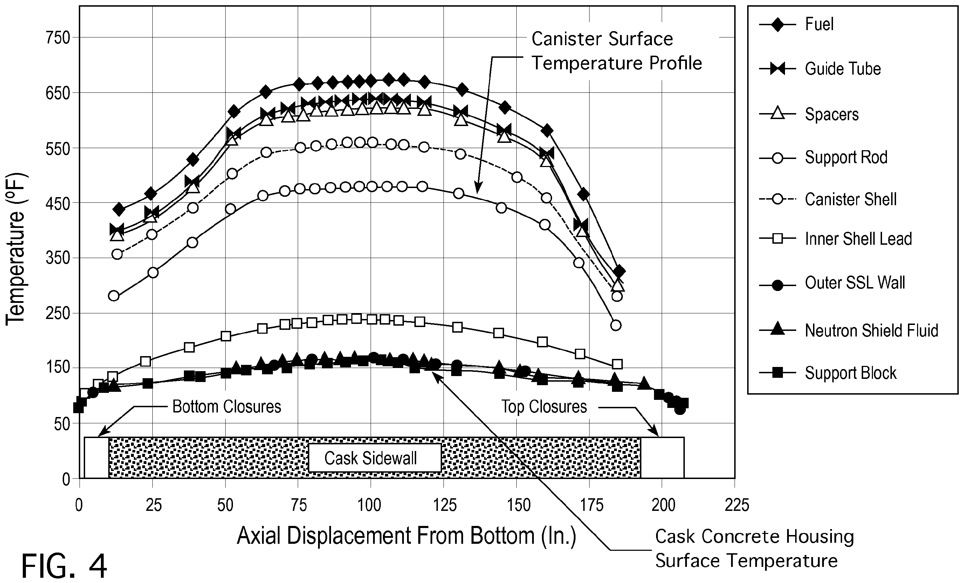

This invention provides a means for converting waste heat from a spent fuel cask into electrical or mechanical power that can be used to support a multitude of functions. In one illustrative embodiment, which is not part of the present invention, thermoelectric generators are mounted on the outer surface of the inner canister of a spent fuel cask. The thermoelectric generators use the delta temperature difference between the inner canister housing the nuclear fuel and the air flow in an annular space between the inner canister and the outer concrete shell to produce power. Typically, commercially available thermoelectric devices will produce significant power when a delta T of 149°C (300°F) or better is placed across the devices. An exemplary thermoelectric device is illustrated in Figure 3 and is generally designated by reference character 72. The thermoelectric device 72 generally consists of two or more elements of N and P-type doped semiconductor material 74 that are connected electrically in series and thermally in parallel. The N-type material is doped so that it will have an excess of electrons (more electrons than needed to complete a perfect molecular lattice structure) and P-type material is doped so that it will have a deficiency of electrons (fewer electrons than are necessary to complete a perfect lattice structure). The extra electrons in the N material and the "holes" resulting from the deficiency of electrons in the P material are the carriers which moves the heat energy from a heat source 76 through the thermoelectric material to a heat sink 78 which, in this case, is the annulus between the liner 22 on the inside of the concrete shell 10 and the inner canister shell 44. The electricity that is generated by a thermoelectric module such as that shown in Figure 3 is proportional to the magnitude of the temperature difference between each side of the module. In accordance with this illustrative embodiment, the thermoelectric generator would be attached around the outer circumference of the inner cylindrical canister 36 in a band located approximately midway along the canister's axial height, which typically is between 75 and 125 inches (190.5 and 317.5 cm) from the bottom of the canister, *i.e.,* approximately one fourth of the canister surface area. This surface area is noted in Figure 2 by reference character 80 and one such thermoelectric generator is figuratively illustrated in Figure 2 and designated by reference character 82. The temperature profile within the casks for different components is given in Figure 4. As can be seen, the canister 36 surface temperature in the middle elevation area is approximately 243°C (470°F). The air temperature will necessarily be greater than the inside of the concrete housing and can be found from an energy balance on this component. Conservatively using the total convective and radiation heat transfer lost from the outer cask surface to the atmosphere, and equating this to the convective heat transfer to the inside of the concrete housing enables an estimate of air temperature within the annulus. Using a free convection heat transfer coefficient of 2.0 B/hr-ft²-degree Fahrenheit, the air temperature is found to be approximately ten degrees warmer than the housing surface or a maximum of 77°C (170°F). Thus, a 149°C (300°F) temperature difference exists between the canister shell 44 and the air stream in the central portion of the annulus between the shell 44 and the inner wall of the concrete outer shell 10.

Application of commercially available thermoelectric generator elements within this defined area will result in a power production of up to 10 kilowatts from each cask. Since the decay heat has already exponentially decayed for a minimum of fifteen years before the fuel assemblies are loaded in the casks, the remaining decay heat levels stay fairly constant, so this power is always available if needed. Once a spent fuel pool is full, each refueling offload requires three additional long-term storage casks, so a total of approximately 30 kilowatts of additional potential power is available every eighteen months, *i*.*e*., the refueling cycle. The thermoelectric generator elements 72 act like individual batteries and can be connected electrically in a combination of parallel and series arrangements to provide voltage and current levels for specific applications. This passively generated power can be used for many important things, for example, during a loss of on-site and off-site power (station blackout). Typically, during such conditions a plant must cope with only backup battery systems to power essential loads. For the AP1000®, a passive nuclear plant design offered by Westinghouse Electric Company LLC, Cranberry Township, Pennsylvania, this coping capability is at least 72 hours, and for older existing plants, the period is much shorter. The power generated from each cask can be used to provide battery charging, control room lighting, instrumentation needs and power to cool a spent fuel pool such as that designated by reference character 84, schematically shown in Figure 1, thereby extending the plant coping time under station blackout conditions.

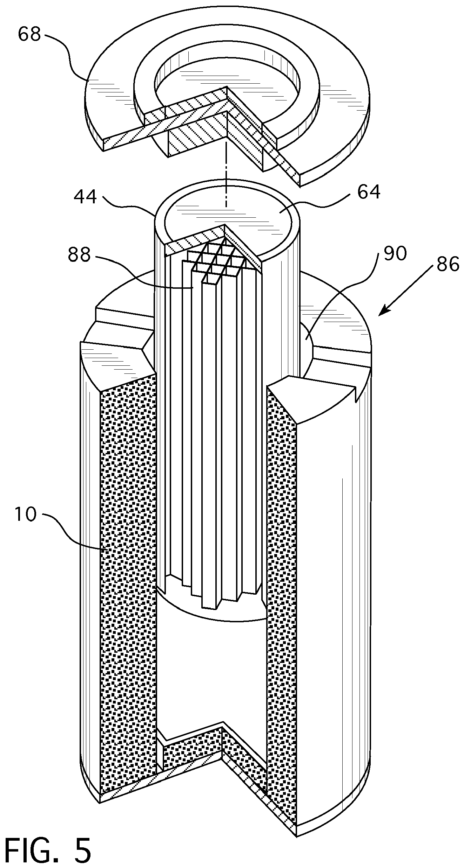

The power produced in each cask 86, shown partially assembled in Figure 5 with the fuel assembly bundles 88 within the inner canister 36, can be used to provide a forced draft of air in the annulus 90, thereby significantly increasing the heat removal capability of the casks 86. For this purpose, a thermoelectric generator element 82 is shown connected by an electrical lead 92 to an air blower or fan 94 that will move the air from the air intake 32 up through the annulus 90 and exhaust the air through the air outlet 38 in the upper portion of the concrete shell 10. Alternately, the blower or fan 94 can be positioned outside the concrete shell 10 and be connected by piping to the intake 32 and outlet 38 while being driven by a thermoelectric element within the annulus 90 powered through leads that extend through the concrete outer shell 10. Either arrangement for forcibly moving air through annulus 90 allows the fuel assemblies to be off loaded from the spent fuel pool at an earlier time and decreases the decay heat load on the spent fuel pool. This has the very positive result of reducing the cooling needs of the pool during station blackout conditions and improves the coping strategy for the plant.

Alternately, a heat pipe 96 can be employed extending through the annulus 90 and through the outer concrete shell 10 to convey the heat generated in the annulus 90 or within the canister 36 to the outside where it can be employed to drive a mechanical heat engine, such as a Stirling cycle or Rankine cycle engine as figuratively illustrated, respectively, by reference characters 98 and 100 in Figure 1. Either of the Stirling cycle or the Rankine cycle engines can be employed to drive the blower 94 to force air through the annulus or drive a pump 102 which can be employed to circulate spent fuel pool water 106 through a heat exchanger 104 where it can be cooled and returned to the spent fuel pool 84. The operation of both the Rankine cycle engine and the Stirling cycle engine is more fully described in Application Serial No. 13/558,443, filed July 26, 2012 (Attorney Docket No. CLS-UFS-001).

In some instances it may not be practical to access the annulus between the outer concrete shield cask shell 10 and the inner canister 44 after the fuel assemblies 88 have been loaded and the cask sealed. This invention contemplates a way to use a heat engine, such as thermoelectric generator technology to utilize the energy from the spent fuel without the need to place any hardware into the cask.

Thermoelectric generator elements operate between two temperatures, as previously mentioned, and in general the performance or energy conversion efficiency will depend on the temperature difference. Using the internal canister shell surface provides a relatively large delta-T between the canister shell and cooling airstream flowing through the annulus. However, there is also a sufficient, though smaller delta-T available between the exhausted cooling air which has absorbed approximately 92% of the decay heat energy and the ambient air in the surroundings. By accepting a lower energy conversion efficiency, it is possible to still utilize thermoelectric generator technology to produce significant useful power without the need for internal cask modifications.

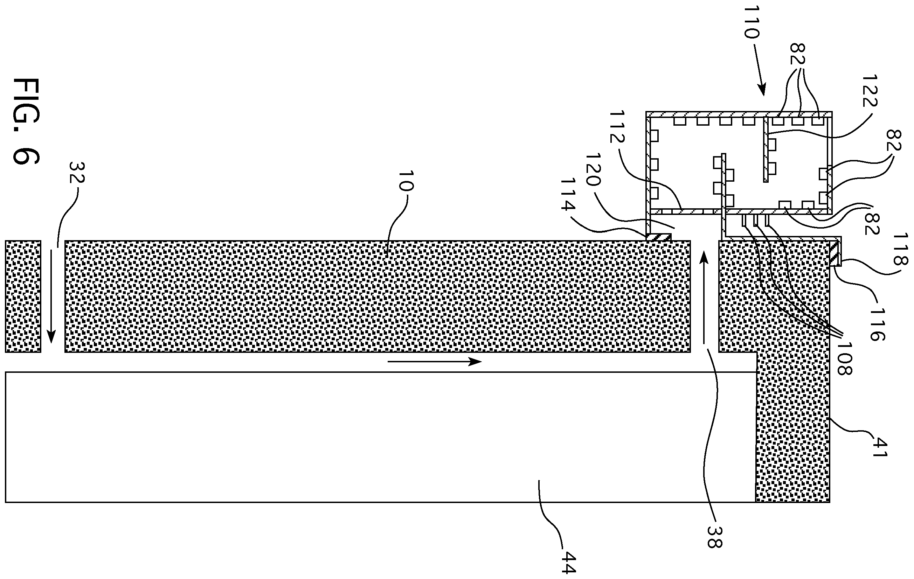

Accordingly, this invention envisions the placement of a baffled support structure that can be positioned over the top of the cask and supported from the robust concrete outer shield shell. The general configuration of one embodiment of this arrangement is shown in Figure 6. Like reference characters are used among the several figures to denote corresponding components. For a circular cask shell 10 the baffle support structure may take the form of an annular cylinder 110 that extends around the cask and is supported from a flange 116 that rests on top of the cask and extends down to the air outlet 38 through the concrete cask shield shell 10. The use of a gasket 118 under the support flange 116 and an elastomer seal 114 around the bottom of the support structure 110 between the support structure and the concrete shell 10 prevents leakage of exhaust airflow prior to entering the baffled region. A series of baffle plates 122 direct the exhaust flow from the air outlet 38 in a serpentine manner before being released to the atmosphere. The inside surface of the support structure walls is lined with individual thermoelectric generators 82 that are directly exposed to the heated exhaust airstream.
The outside surface of the support structure walls is exposed to the cooler ambient air. The support structure material is made from an alloy with relatively high thermal conductivity such as aluminum. If needed, fins 108 are added to this outer surface to promote heat transfer between the ambient environment and the support structure. A perforated plate 112 can be provided at the inlet to the baffle structure to distribute the airstream over the baffle walls. Since the air outlets 38 are typically, circumferentially spaced around the concrete cask at discrete locations the perforated plate 112 acts to distribute the airstream around the annulus within the cylindrical baffle arrangement.

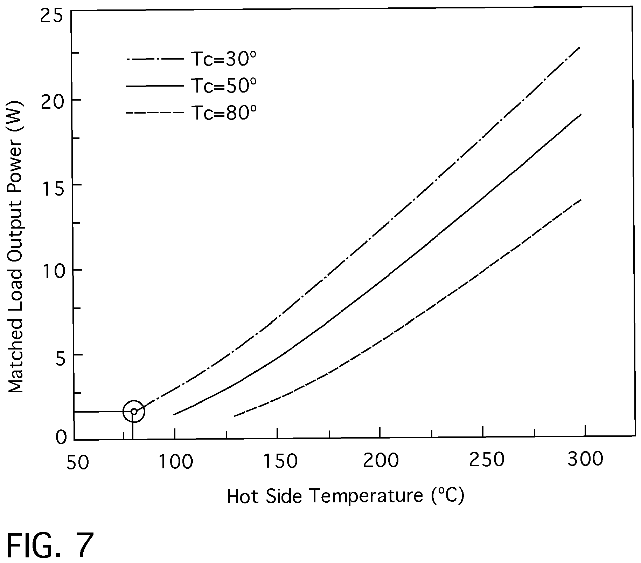

The amount of electrical energy that can be derived from a cask in this manner will vary with the type of thermoelectric generator used, but the performance of a representative example (Tellurex model 02-56-0375) is shown in Figure 7. The air temperature leaving the cask will depend on the local heat transfer characteristics within the cask annulus and the mass flow of air. Using thermal data given in the BNFL W21 Canister Storage FSAR, the exhaust temperature of the airstream leaving the cask is calculated to be about 103 degrees C. With a 25-30 degree C ambient, the power produced from a single thermoelectric generator element is seen to be about 2.5 Watts.
By utilizing the cylindrical areas shown in Figure 6 for mounting the thermoelectric generator elements, it is possible to generate approximately 3 kW of DC power for every 25 cm (10 inches) of height. As energy is extracted from the air, the temperature will decrease reducing the power output of the downstream elements. For each 3 kW of thermoelectric generator power, the airstream temperature is calculated to drop by about 10 degrees C, so the practical limit might be two areas of thermoelectric generator elements with a total power output of about 6 kW per cask. For an older plant with perhaps 20 casks on site, this represents potentially 120 kW of steady DC power that is available all the time which can be very significant during a station blackout scenario for powering instrumentation, ventilation fans, small pumps or other equipment needed to maintain plant safety. By way of comparison, the station blackout load post 72 hours for the APIOOO® plant, which would use the on-site ancillary diesel powered generators is about 35 kW.

Thus, the invention provides a very practical way of passively producing DC electric power at any site that has stored spent fuel casks. While specific embodiments of the invention have been described in detail, it will be appreciated by those skilled in the art that various modifications and alternatives to those details could be developed in light of the overall teachings of the disclosure. Accordingly, the particular embodiments disclosed are meant to be illustrative only and not limiting as to the scope of the invention as defined by the appended claims.

## Claims

1. A spent nuclear fuel storage container (86) comprising:
a canister (22) for storing irradiated nuclear fuel (88);
a heat engine (82) in heat transfer relationship with the canister (86) for converting a differential in heat between the latent heat of the stored nuclear fuel (88) and an ambient environment into electrical or mechanical power;
a fluid circulation system for circulating a cooling fluid over at least a portion of a circumference of the canister (22), the fluid circulation system having a fluid inlet (32) and a fluid outlet (38) which extends through a shield cask (10) that surrounds the canister; and
**characterized by** a fluid baffle system (122) in fluid communication with the fluid outlet (38) which is supported on the shield cask (10), wherein the heat engine (82) is supported, at least in part, in the fluid baffle system in heat exchange relationship with the fluid exhausted from the fluid outlet and the fluid baffle system (122) is a substantially annular passage (120) that fits around the shield cask (10).

2. The spent nuclear fuel storage container (86) of Claim 1 including:
an outer cask (10) surrounding the canister (22) with an annular space (90) therebetween;
an air intake (32) through a lower end of the cask (10) extending from outside the cask to the annular space (90);
an air outlet (38) through an upper end of the cask (10) extending from the annular space (90) to the outside of the cask; and
wherein the heat engine (82) is in heat transfer relationship with the annular space (90).

3. The spent nuclear fuel storage container (86) of Claim 2 wherein the heat transfer relationship is implemented through a heat transfer medium to transport heat from the annular space to an exterior of the outer cask (10).

4. The spent nuclear fuel storage container (86) of Claim 3 wherein the heat transfer medium is a heat pipe (96).

5. The spent nuclear fuel storage container (86) of Claim 2 wherein the heat engine is selected from a Rankine cycle engine (100), a Stirling cycle engine (98) and a thermoelectric device (82).

6. The spent nuclear fuel storage container (86) of Claim 1 wherein the heat engine (82) has an electrical output that is connected to a coolant circulation system operable to cool a coolant.

7. The spent nuclear fuel storage container (86) of Claim 1 wherein the electric power forms an emergency auxiliary power source for a nuclear power plant (84).

8. The spent nuclear fuel storage container (86) of Claim 1, wherein the fluid baffle system (122) is supported from an upper portion of the shield cask.

9. The spent nuclear fuel storage container (86) of Claim 1 wherein the fluid circulation system has a plurality of fluid outlets (38) circumferentially spaced around the shield cask and the fluid baffle system (122) is in fluid communication with at least several of the fluid outlets, including a perforated plate (112) supported within the fluid baffle system, in fluid communication with the fluid outlet, the perforated plate extending at least partially through the fluid baffle system for distributing the fluid over a fluid path through the baffle system.

10. The spent nuclear fuel storage container (86) of Claim 1 wherein the heat engine (82) is a plurality of thermoelectric generators that are supported through a fluid path through the fluid baffle system.

11. The spent nuclear fuel storage container (86) of Claim 10 wherein fins extend on the outside of fluid baffle system (122) to promote heat transfer.

12. The spent nuclear fuel storage container (86) of Claim 1 wherein the fluid baffle system (122) has a fluid path that extends vertically in a serpentine course.

## Patentansprüche

1. Lagerbehälter (86) für abgebrannten Kernbrennstoff, umfassend:
einen Kanister (22) zum Lagern von verstrahltem Kernbrennstoff (88);
einen Wärmemotor (82) in wärmeübertragender Beziehung mit dem Kanister (86) zur Umwandlung eines Wärmedifferentials zwischen der latenten Wärme des gelagerten Kernbrennstoffs (88) und einer umliegenden Umgebung in elektrische oder mechanische Leistung;
ein Fluidzirkulationssystem zum Zirkulieren eines Kühlfluids über zumindest einen Abschnitt eines Umfangs des Kanisters (22), wobei das Fluidzirkulationssystem einen Fluideinlass (32) und einen Fluidauslass (38) aufweist, die sich durch ein Abschirmgebinde (10) erstrecken, das den Kanister umgibt; und
**gekennzeichnet durch**
ein Fluidumlenksystem (122) in Fluidverbindung mit dem Fluidauslass (38), das an dem Abschirmgebinde (10) getragen wird, wobei der Wärmemotor (82) zumindest zum Teil in dem Fluidumlenksystem in wärmetauschender Beziehung mit dem Fluid, das von dem Fluidauslass ausgestoßen wird, getragen wird, und wobei das Fluidumlenksystem (122) ein im Wesentlichen ringförmiger Durchgang (120) ist, der um das Abschirmgebinde (10) herum passt.

2. Lagerbehälter (86) für abgebrannten Kernbrennstoff nach Anspruch 1, umfassend:
ein äußeres Gebinde (10), das den Kanister (22) mit einem ringförmigen Raum (90) dazwischen umgibt;
einen Lufteinlass (32) durch ein unteres Ende des Gebindes (10), der sich von außerhalb des Gebindes zu dem ringförmigen Raum (90) erstreckt;
einen Luftauslass (38) durch ein oberes Ende des Gebindes (10), der sich von dem ringförmigen Raum (90) bis außerhalb des Gebindes erstreckt; und
wobei der Wärmemotor (82) in wärmeübertragender Beziehung mit dem ringförmigen Raum (90) steht.

3. Lagerbehälter (86) für abgebrannten Kernbrennstoff nach Anspruch 2, wobei die wärmeübertragende Beziehung durch ein Wärmeübertragungsmedium implementiert ist, um Wärme von dem ringförmigen Raum zu einer Außenseite des äußeren Gebindes (10) zu transportieren.

4. Lagerbehälter (86) für abgebrannten Kernbrennstoff nach Anspruch 3, wobei das Wärmeübertragungsmedium ein Wärmerohr (96) ist.

5. Lagerbehälter (86) für abgebrannten Kernbrennstoff nach Anspruch 2, wobei der Wärmemotor ausgewählt ist aus einem Rankine-Motor (100), einem Stirling-Motor (98) und einer thermoelektrischen Vorrichtung (82).

6. Lagerbehälter (86) für abgebrannten Kernbrennstoff nach Anspruch 1, wobei der Wärmemotor (82) einen elektrischen Ausgang aufweist, der mit einem Kühlmittelzirkulationssystem verbunden ist, das betätigbar ist, um ein Kühlmittel zu kühlen.

7. Lagerbehälter (86) für abgebrannten Kernbrennstoff nach Anspruch 1, wobei die elektrische Leistung eine Notfall-Zusatzleistungsquelle für ein Kernkraftwerk (84) bildet.

8. Lagerbehälter (86) für abgebrannten Kernbrennstoff nach Anspruch 1, wobei das Fluidumlenksystem (122) von einem oberen Abschnitt des Abschirmgebindes getragen wird.

9. Lagerbehälter (86) für abgebrannten Kernbrennstoff nach Anspruch 1, wobei das Fluidzirkulationssystem eine Vielzahl von Fluidauslässen (38) aufweist, die in Umfangsrichtung um das Abschirmgebinde herum beabstandet sind, und das Fluidumlenksystem (122) in Fluidverbindung mit zumindest mehreren der Fluidauslässe steht, und eine Lochplatte (112) umfasst, die innerhalb des Fluidumlenksystems in Fluidverbindung mit dem Fluidauslass getragen wird, wobei sich die Lochplatte zumindest teilweise durch das Fluidumlenksystem erstreckt, um das Fluid über einen Fluidpfad durch das Umlenksystem zu verteilen.

10. Lagerbehälter (86) für abgebrannten Kernbrennstoff nach Anspruch 1, wobei der Wärmemotor (82) aus einer Vielzahl von thermoelektrischen Generatoren besteht, die über einen Fluidpfad durch das Fluidumlenksystem getragen werden.

11. Lagerbehälter (86) für abgebrannten Kernbrennstoff (86) nach Anspruch 10, wobei sich von der Außenseite des Fluidumlenksystems (122) Rippen erstrecken, um die Wärmeübertragung zu fördern.

12. Lagerbehälter (86) für abgebrannten Kernbrennstoff nach Anspruch 1, wobei das Fluidumlenksystem (122) einen Fluidpfad aufweist, der sich vertikal in einem schlangenförmigen Verlauf erstreckt.

## Revendications

1. Récipient de stockage (86) de combustible nucléaire irradié, comprenant :
un réservoir (22) pour stocker du combustible nucléaire irradié (88) ;
un moteur thermique (82) en relation de transfert de chaleur avec le réservoir (86) pour convertir une différentiel de chaleur entre la chaleur latente du combustible nucléaire stocké (88) et un environnement ambiant en puissance électrique ou mécanique ;
un système de circulation de fluide pour circuler un fluide caloporteur dans au moins une portion d'une circonférence du réservoir (22), le système de circulation de fluide ayant une entrée de fluide (32) et une sortie de fluide (38) s'étendant à travers un fût de blindage (10) entourant le réservoir ; et
**caractérisé par :**
un système déflecteur de fluide (122) en communication fluidique avec la sortie de fluide (38) supporté sur le fût de blindage (10), le moteur thermique (82) étant supporté au moins partiellement dans le système déflecteur de fluide en relation de transfert de chaleur avec le fluide évacué de la sortie de fluide, et le système déflecteur de fluide (122) est un passage (120) sensiblement annulaire qui s'adapte autour du fût de blindage (10).

2. Récipient de stockage (86) de combustible nucléaire irradié selon la revendication 1, comportant :
un fût extérieur (10) entourant le réservoir (22) avec un espace annulaire (90) entre eux ;
une entrée d'air (32) à travers une extrémité inférieure du fût (10) s'étendant d'un extérieur du fût jusqu'à l'espace annulaire (90) ;
une sortie d'air (38) à travers une extrémité supérieure du fût (10) s'étendant à partir de l'espace annulaire (90) jusqu'à l'extérieur du fût ; et
dans lequel le moteur thermique (82) est en relation de transfert de chaleur avec l'espace annulaire (90).

3. Récipient de stockage (86) de combustible nucléaire irradié selon la revendication 2, dans lequel la relation de transfert de chaleur est mise en oeuvre par un milieu de transfert de chaleur pour transporter la chaleur de l'espace annulaire à l'extérieur du fût extérieur (10).

4. Récipient de stockage (86) de combustible nucléaire irradié selon la revendication 3, dans lequel le milieu de transfert de chaleur est un caloduc (96).

5. Récipient de stockage (86) de combustible nucléaire irradié selon la revendication 2, dans lequel le moteur thermique est choisi parmi un moteur Rankine (100), un moteur Stirling (98) et un dispositif thermoélectrique (82).

6. Récipient de stockage (86) de combustible nucléaire irradié selon la revendication 1, dans lequel le moteur thermique (82) a une sortie électrique reliée à un système de circulation de caloporteur opérable pour refroidir un caloporteur.

7. Récipient de stockage (86) de combustible nucléaire irradié selon la revendication 1, dans lequel la puissance électrique constitue une source d'énergie auxiliaire de secours pour une centrale nucléaire (84).

8. Récipient de stockage (86) de combustible nucléaire irradié selon la revendication 1, dans lequel le système déflecteur de fluide (122) est supporté d'une portion supérieure du fût de blindage.

9. Récipient de stockage (86) de combustible nucléaire irradié selon la revendication 1, dans lequel le système de circulation de fluide a une pluralité de sorties de fluide (38) circonférentiellement espacées autour du fût de blindage, et le système déflecteur de fluide (122) est en communication fluidique avec au moins plusieurs des sorties de fluide, comprenant une plaque perforée (112) supportée à l'intérieur du système déflecteur de fluide, en communication fluidique avec la sortie de fluide, la plaque perforée s'étendant au moins partiellement à travers le système déflecteur de fluide pour distribuer le fluide sur un trajet de fluide à travers le système déflecteur.

10. Récipient de stockage (86) de combustible nucléaire irradié selon la revendication 1, dans lequel le moteur thermique (82) est une pluralité de générateurs thermoélectriques supportés sur un trajet de fluide à travers le système déflecteur de fluide.

11. Récipient de stockage (86) de combustible nucléaire irradié selon la revendication 10, dans lequel des ailettes s'étendent sur l'extérieur de système déflecteur de fluide (122) pour favoriser le transfert de chaleur.

12. Récipient de stockage (86) de combustible nucléaire irradié selon la revendication 1, dans lequel le système déflecteur de fluide (122) présente un trajet de fluide qui s'étend verticalement dans un parcours serpentin.
